Europäisches Patentamt

(19) European Patent Office

Office européen des brevets

(11) Publication number: **0 457 592 A2**

(12) # EUROPEAN PATENT APPLICATION

(21) Application number: **91304410.3**

(22) Date of filing: **16.05.91**

(51) Int. Cl.⁵: **H01L 21/48, H01L 23/495**

(30) Priority: **18.05.90 JP 130084/90**

(43) Date of publication of application:
**21.11.91 Bulletin 91/47**

(84) Designated Contracting States:
**DE FR GB**

(71) Applicant: **SHINKO ELECTRIC INDUSTRIES CO. LTD.**
**711, Aza Shariden Oaza Kurita**
**Nagano-shi Nagano, 380 (JP)**

(72) Inventor: **Tokita, Masakuni**
**Asama-sou, 4-7-22 Uematsu**
**Nagano-shi, Nagano 380 (JP)**

Inventor: **Kobayashi, Akira**
**2007 Obuse-machi**
**Kamitakai-gun, Nagano 381-02 (JP)**
Inventor: **Yamakawa, Shinichi**
**612-2, Imasato, Kawanakazima-machi**
**Nagano-shi, Nagano 381-22 (JP)**
Inventor: **Shimizu, Mitsuharu**
**195 Wakasato**
**Nagano-shi, Nagano 380 (JP)**
Inventor: **Masuda, Norihiro**
**4-20-22, Miwa**
**Nagano-shi, Nagano 380 (JP)**

(74) Representative: **Rackham, Stephen Neil et al**
**GILL JENNINGS & EVERY 53-64 Chancery Lane**
**London WC2A 1HN (GB)**

(54) **Process for manufacturing a multi-layer lead frame.**

(57)   A process for manufacturing a multi-layer lead frame for a semiconductor device comprising at least two metal components (12,20,32) adhered to one another via an insulation tape piece (42). The metal components (12,20,32) and the insulation tape pieces (42) are all surrounded by supporting frames (14,24,36,46) including positioning means (16,28,39,48) such as holes to ensure that they are aligned correctly. Then the insulation strip (40) is punched to cut the insulation piece (42), which is preliminarily adhered to one metal component strip (10,18,30). The metal strip (10,18,30) is then punched to cut and remove the metal component (12,20,32) which is then laminated and heat-pressed to another metal strip (10,18,30). After it is completely adhered, the other metal strip (10,18,30) is punched to remove the multi-layer lead frame assembly or sub-assembly.

EP 0 457 592 A2

This invention relates to a process for manufacturing a lead frame, more particularly to a process for manufacturing a multi-layer lead frame having at least one metal plate or plane, hereinafter referred to as "metal plane" which is used for a semiconductor device.

A plastic package, whose speed and heat-radiation characteristics are as good as those of a ceramic package,has recently been developed. In addition, in place of a conventional single-layer lead frame, a multi-layer plastic lead frame for a semiconductor device has also been developed.

Such a multi-layer lead frame comprises at least one metal plane connected via an insulative layer to the bottom surfaces of inner leads. Using such a multi-layer lead frame, it will be possible to mount a relatively power consumable semiconductor chip on the metal plane, due to a good heat radiation capacity of the metal plane. Also, the metal plane can be used as a ground layer or a power supply layer to improve the electrical characteristics of the semiconductor device.

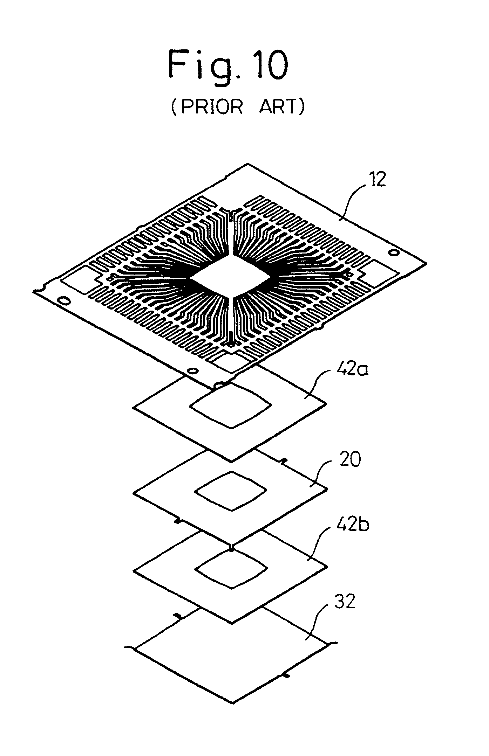

Figure 10 shows a conventionally known multi-layer lead frame which comprises three layers, i.e., a signal layer (i.e., lead frame 12) and two metal planes, i.e., a power supply metal plane 20 and a ground metal plane 32, which are laminated via insulative tapes 42a and 42b made of heat-resistant material, such as a polyimide.

Using such a multi-layer lead frame, it would be possible to prevent a so-called cross talk which might be generated between signal lines and also possible to reduce the capacitance or inductance between the lines.

As shown in Fig. 10, in order to manufacture the above-mentioned multi-layer lead frame, at the first stage, a lead frame 12, a power supplying metal plane 20, a ground metal plane 32, and insulative tape pieces 42a and 42b each having respective surfaces providing with adhesive layers must individually be made. Then, these individual pieces must be positioned by using a special positioning instrument including a CCD array or a special instrument, such as an image reader (not shown), and then heat-pressed to laminate and adhere them together.

However, in the above mentioned manufacturing process, it has been so troublesome and laborious work to position and laminate the five layers including the insulative tape pieces 42a and 42b by using the positioning instrument. It also requires a lot of time and, therefore, an effective production would not be expected. In addition, when these pieces are released or disengaged from the gripping means after the pieces are gripped by the gripping means and laminated, the laminated pieces might be moved slightly and, therefore, a precise laminated multi-layer lead frame might not be obtained.

The multi-layer lead frame should originally have a good quality for mulit-pin and, therefore, inner leads thereof are usually so dense. Thus, even a slight abberation might cause a disconnection between the terminals of the power supply plane 20 or the ground plane 32 and the corresponding inner leads of the lead frame 10.

According to this invention, a process for manufacturing a multi-layer lead frame for a semiconductor device comprising at least two metal components adhered to one another by means of an insulation tape piece comprising the steps of:

forming a first metal component and a second metal component from metal strip;

forming at least one insulation tape piece with adhesive layers on its respective surfaces; and,

positioning the first and second metal components and the insulation tape piece with the insulation tape sandwiched between the two metal components to adhere them together;

is characterised in that the first component is formed as part of a first component strip comprising a plurality of first components longitudinally and continuously arranged and connected to a first supporting frame via first connecting portions;

in that the second component is formed as part of a second component strip comprising a plurality of the second components longitudinally and continuously arranged and connected to a second supporting frame via second connecting portions;

in that the insulation tape piece is formed as part of an insulation tape strip comprising a plurality of the insulation tape pieces longitudinally and continuously arranged and connected to a third supporting frame (46) via third connecting portions;

in that each of the first, second and third supporting frames have positioning means, such as guide holes;

in that the insulation tape strip is positioned with respect to the first or second component strip by their positioning means;

in that the insulation tape strip is punched to cut or remove at least one of the insulation tape pieces from the third connecting portions and provisionally adhere it to the first or second component strip;

in that the first component strip is positioned with respect to the second component strip;

in that the first component strip is punched to cut and remove the first component and laminating to heat press and completely adhere it to the second component strip; and,

in that the second component strip is punched to cut and remove the second component.

Thus, according to the present invention, the lead frame base and/or the metal planes can be precisely and effectively positioned, since the positioning of the lead frame strip and/or the metal plane strips can be easily and precisely conducted.

Particular embodiments of processes in accordance with this invention will now be described with reference to the accompanying drawings; in which:-

Figure 1 is a schematic view illustrating a manufacturing process of the multi-layer lead frame;

Figures 2, 3, 4 and 5 are plan views of the lead frame strip, the power supply plane, the ground plane, and the insulation tape strip, respectively;

Figures 6, 7, 8 and 9 are schematic cross-sectional views of heat pressing devices; and,

Figure 10 is an exploded view of a multi-layer lead frame known in the prior art.

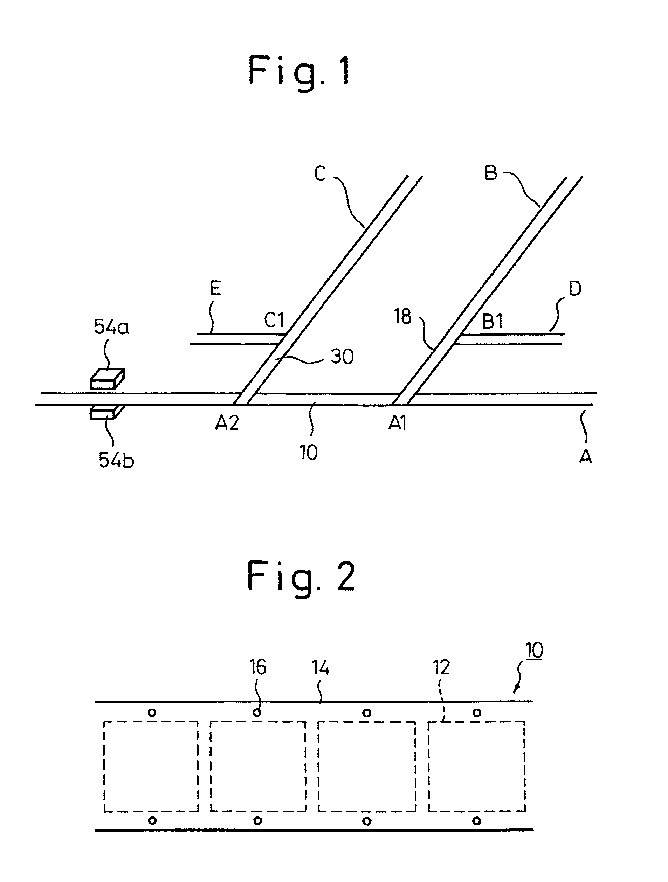

Referring now to the drawings, Figs. 1-8 show a preferred embodiment of a process for manufacturing a multi-layer lead frame according to the present invention.

A multi-layer lead frame can be manufactured by a process as described below with reference to Fig. 1, in which, A is a line of process for manufacturing a lead frame strip 10, B is a line of process for manufacturing a power supply plane strip 18, and C is a line of process for manufacturing a ground plane strip 30. D and E are also lines of process for providing insulation tapes.

In the process line A, a metal strip 10 is forwardly fed through several metal molds (not shown). Along these molds the lead frame strip 10 is formed in a conventionally known manner. Thus, as schematically shown in Fig. 2, obtained is a lead frame strip 10 comprising a support frame 14 and a plurality of lead frames 12 longitudinally and continuously arranged and connected to each other by means of connecting portions. The support frame 14 is provided with a plurality of regularly arranged guide holes 16 which cooperate with guide means (not shown) for feeding this lead frame strip 10 forwardly through the metal molds.

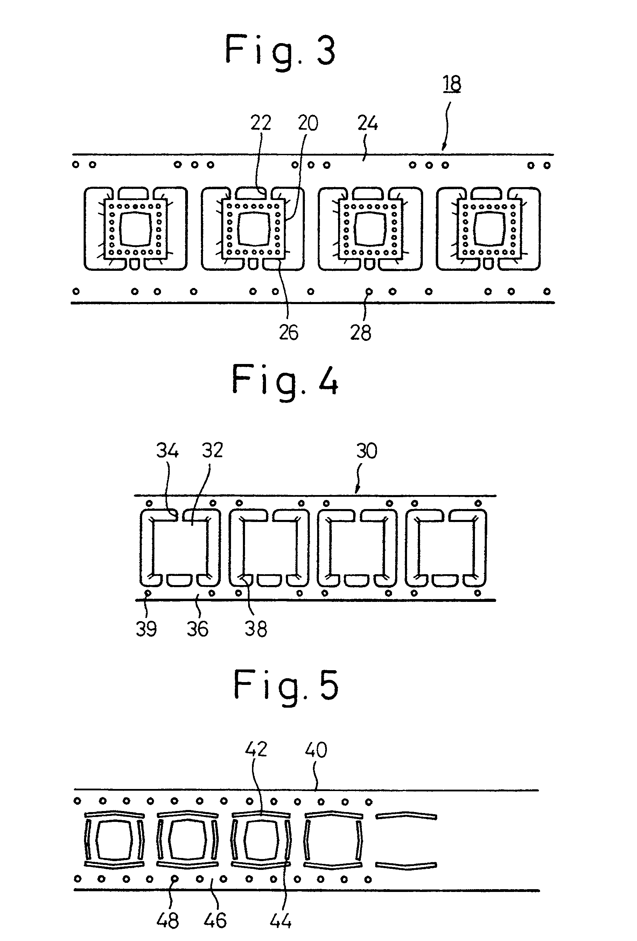

The process line B intersects perpendicularly with the process line A at a position A1 downstream of the working stations for entirely forming all of the patterns of the lead frame strip 10. In the process line B, another metal strip is fed forwardly through several metal molds (not shown) to form a power supply plane strip 18 which comprises, as shown in Fig. 3, a plurality of power supply planes 20 longitudinally and continuously arranged and connected to a supporting frame 24 by means of connecting portions 22. A reference numeral 26 indicates terminals which are protruded from the power supply plane 20. Such terminals 26 are connected to predetermined power supply leads of the lead frame 12 when the power supply plane 20 is laminated to the lead frame 12. A reference numeral 28 indicates positioning guide holes which are used for feeding the power supply plane strip 18 through the metal molds, as mentioned above.

The process line C also intersects perpendicularly with the process line A at a position A2 downstream of the intersection with the process line B. In the same manner as the above, in the process line C, a still another metal strip is fed forwardly through several metal molds (not shown) to form a ground plane strip 30 which comprises, as shown in Fig. 4, a plurality of ground planes 32 longitudinally and continuously arranged and connected to a supporting frame 36 by means of connecting portions 34. A reference numeral 38 indicates terminals which are protruded from the ground plane 32. Such terminals 38 are connected to predetermined ground leads of the lead frame 10, when the ground plane 32 is laminated to the lead frame 10. A reference numeral 39 indicates positioning guide holes which are used for feeding the ground plane strip 30 through the metal molds, as mentioned above.

The process line D for forming a first insulation tape strip 40 is arranged to intersect perpendicularly with the process line B at a position downstream of a final step for forming the power supply plane strip 18 in the process line B.

In this process line D, a resin strip is fed forwardly through several metal molds (not shown) to form a frame like insulation tape strip 40 which comprises, as shown in Fig. 5, a plurality of insulation tape pieces 42 longitudinally and continuously arranged and connected to a supporting frame 46 by means of connecting portions 44. Such an insulation tape piece 42 is used for adhering the lead frame 12 to the power supply plane 20. A reference numeral 48 indicates guide holes.

The above-mentioned insulation tape strip 40 may be a so-called double sided adhesive tape comprising a heat-resistant resin sheet made of, such as, a polyimide and having respective surfaces to which suitable resin paste comprising, such as, a thermosetting resin contained in any solution media is coated and dried to form adhesive layers.

The insulation tape piece 42 of the first insulation tape strip 40 is cut from the connecting portion 44 at the intersection of the process line B and provisionally adhered to the bottom surface of the power supply plane 20 (strip 18) at a predetermined position.

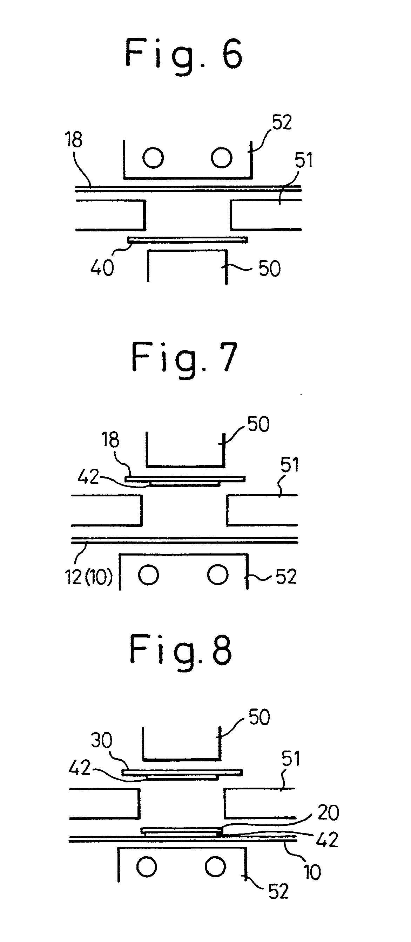

Fig. 6 shows an example of the heat press apparatus which comprises a cutting punch 50, a die 51, and a heater block 52. When the insulation tape strip 40 is positioned by means of the above-mentioned guide holes 48 and fed to a predetermined position between the cutting punch 50 and the die 51, the cutting punch 50 is moved upward to cut the connecting portions 44, so that the insulation tape strip 40 is cut into the individual insulation tape piece 42, which is then heat-pressed against the power supply plane 20 (strip 18) provisionally heated by the heater block 52. The heat-pressing in this process is conducted at the temperature of, such as 180°C, which is sufficient to soften the adhesion of the insulation tape piece 42 to be adherent, but not to completely harden the thermosetting adhesive.

After the insulation tape pieces 42 are removed from the insulation tape strip 40, the supporting frame 46 is wound onto an appropriate reel (not shown).

The pressing surface of the cutting punch 50 may be provided with some suction holes communicated to any vacuum means (not shown) for sucking to hold the cut insulation tape piece 42 and simultaneously to press the same against the power supply plane 20 (strip 18). Thus, the insulation tape piece 42 is held stably against the power supply plane 20 (strip 18).

The process line E for forming a second insulation tape strip 40 is arranged to intersect perpendicularly with the process line C at a position downstream of a final step for forming the ground plane strip 30 in the process line C. In this process line E, a resin strip is fed forwardly through several metal molds (not shown) to form a frame-like insulation tape strip 40 in the same manner as the above. Thus, the insulation tape piece 42 is used for preliminary adhering the ground plane 32 to the power supply plane 20.

The second insulation tape strip 40 is cut from the connecting portion 44 into the insulation tape piece 42 at the intersection of the process line C. The insulation tape piece 42 is provisionally adhered to the bottom surface of the ground plane 32 at a predetermined position.

After the first and second insulation tape strips 40 are cut into the individual insulation tape pieces 42 and heat-pressed against the power supply plane 20 (strip 18) and the ground plane 32 (strip 30), respectively, the latters are then further fed to the intersections with the process line A.

Fig. 7 shows an example of a heat press apparatus which is substantially the same as that shown in Fig. 6, except that the cutting punch 50 is arranged upside and the die 51 and the heater block 52 are arranged downside. When the power supply strip plane 18, to which the insulation tape piece 42 is preliminary adhered, is positioned by means of the above-mentioned guide holes 28 and fed to a predetermined position A1 (Fig. 1) between the cutting punch 50 and the die 51, the cutting punch 50 is moved downward to cut the connecting portions 22, so that the power supply plane strip 18 is cut into the individual power supply strip 20, which is then heat-pressed against lead frame 12 provisionally heated by the heater block 52.

Thus, the lead frame strip 10, to which the power supply plane 20 adhered by means of the insulation tape piece 42, is further fed forwardly and, at the intersection A2 (Fig. 1) of the process line C, the ground plane 32, to which the first insulation tape piece 42 is provisionally adhered, is then provisionally adhered to the power supply plane 20 by means of the second insulation tape piece 42, in the same manner as mentioned above. That is to say, as shown in Fig. 8, when the lead frame strip 10 and the ground plane strip 30 are positioned to each other by means of the respective guide holes and fed forwardly to the intersection A2 of the process line C, the cutting punch 50 is lowered to cut the ground plane strip 30 from the connecting portions 34 into the individual ground plane 32, which is then heat-pressed against the power supply plane 20 on the lead frame strip 10 provisionally heated by the heater block 52 to soften the adhesive of the insulation tape piece 42 to preliminary adhere the ground plane 32 against the power supply plane 20.

Thus, the lead frame 12, to which the power supply plane 20 and the ground plane strip 32 are laminated, is further fed forwardly along the process line A and is further heated and pressed by upper and lower heater blocks 54a and 54b. Thus, the adhesive tapes or layers of the insulation tape pieces 42 are suitably thermoset and, therefore, a stable main or compete adhering is thus conducted.

The respective terminals of the power supply plane 20 and the ground plane strip 32 are connected to the corresponding leads of the lead frame 12 by a spot welding or the like.

According to the above-mentioned embodiment, by synchronizingly operating the respective process lines A, B, C, D and E, the lead frame 12, the first and second insulation tape pieces 42, the power supply plane 20 and the ground plane 32 can automatically be formed. Also, the provisional adhering, the heat-pressing and the positioning of the insulation tape pieces 42 can automatically be conducted. A multi-layer lead frame of this invention can thus be automatically manufactured throughout the whole steps.

However, such a synchronizing operation can be partly conducted. For example, the operations for forming and heat-pressing of the power supply plane strip 18 and the first insulation tape 42 are synchronized to each other and, on the other hand, the operations for forming and heat-pressing the ground plane strip 30 and the second insulation tape 42 are synchronized to each other. Laminating and heat-pressing of the power supply plane 20, to which the insulation tape 42 is attached, the ground plane 32, and the lead frame strip 10 can be synchronizing operated as mentioned above in a separate process.

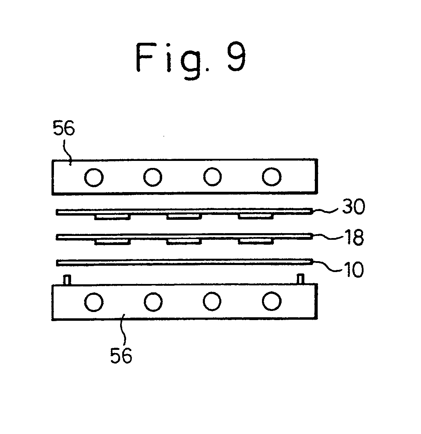

Fig. 9 shows another embodiment of a laminating process. In this embodiment, the power supply plane strip 18, to which the first insulation tape pieces 42 are adhered, and the ground plane 32, to which the second insulation tape pieces 42 are adhered, are not cut into individual planes. But these strips 18 and 30 are themselves positioned by any positioning means, such as pilot pins, and superimposed on the lead frame strip 10, so that they are heat-pressed together by means of upper and lower heater blocks 56 and 56 to thermoset the adhesive tape layers of the fist and second insulation tape pieces 42. The power supply plane strip 18 and the ground plane strip 30 are thereafter cut into individual planes 20 and 32 from the frame portions thereof. The connecting portions 22 and 34 may be provided at the bases thereof with v-shaped notches or the like extending to the direction of thickness so as to make it easy to cut the connecting portions.

In this embodiment, the first insulation tape piece 42 for adhering the power supply plane 20 to the lead frame 12 may be provisionally adhered to the lead frame strip 10. On the other hand, the second insulation tape piece 42 for adhering the ground plane 32 to the power supply plane 20 may be provisionally adhered to the power supply plane strip 18.

Although, in the above mentioned embodiments, a multilayer lead frame comprises three layers, i.e., the lead frame, the power supply plane and the ground plane, this invention is also applicable to any other multi-layer lead frames comprising, such as, two layers, i.e., a lead frame and a metal plane. In this case, the metal plane may be a power supply plane, a ground plane, or a radiation/stage plane which is not electrically connected to the lead frame.

A multi-layer lead frame thus obtained according to the present invention may, of course, be comprised of four or more layers.

**Claims**

1. A process for manufacturing a multi-layer lead frame for a semiconductor device comprising at least two metal components (12,20,32) adhered to one another by means of an insulation tape piece (42a,42b) comprising the steps of:

　　　forming a first metal component (12,20,32) and a second metal component (12,20,32) from metal strip;

　　　forming at least one insulation tape piece (42a,42b) with adhesive layers on its respective surfaces; and,

　　　positioning the first and second metal components (12,20,32) and the insulation tape piece (42a,42b) with the insulation tape (42) sandwiched between the two metal components to adhere them together;

　　　characterised in that the first component (12,20,32) is formed as part of a first component strip (10,18,30) comprising a plurality of first components (12,20,32) longitudinally and continuously arranged and connected to a first supporting frame (14,24,36) via first connecting portions (22,34);

　　　in that the second component (12,20,32) is formed as part of a second component strip (10,18,30) comprising a plurality of the second components (12,30,32) longitudinally and continuously arranged and connected to a second supporting frame (14,24,36) via second connecting portions (22,34);

　　　in that the insulation tape piece (42) is formed as part of an insulation tape strip (40) comprising a plurality of the insulation tape pieces (42) longitudinally and continuously arranged and connected to a third supporting frame (46) via third connecting portions (44);

　　　in that each of the first, second (14,24,36) and third (46) supporting frames have positioning means (16,28,39,48), such as, guide holes;

　　　in that the insulation tape strip (40) is positioned with respect to the first or second component strip (10,18,30) by their positioning means;

　　　in that the insulation tape strip (40) is punched to cut or remove at least one of the insulation tape pieces (42) from the third connecting portions (44) and provisionally adhere it to the first or second component strip (10,18,30);

　　　in that the first component strip (10,18,30) is positioned with respect to the second component strip (10,18,30);

　　　in that the first component strip (10,18,30) is punched to cut and remove the first component (12,20,32) and laminating to heat press and completely adhere it to the second component strip (10,18,30); and,

　　　in that the second component strip (10,18,30) is punched to cut and remove the second component (12,20,32).

2. A process according to claim 1, in which the first and second component strips (10,18,30) are positioned with respect to one another by their positioning means (16,28,39).

3. A process according to claim 1 or 2, in which the first component is a lead frame (12) and the second component is a metal plane (20,32).

4. A process according to claim 1 or 2, in which the first component is a first metal plane (20) and the second component is a second metal plane (32).

5. A process according to claim 1, in which the metal components in the multi-layer lead frame include a lead frame (12) and at least two metal planes (20,32); in which the process includes the step of providing a second insulation tape strip (40) comprising a plurality of insulation tape pieces (42) longitudinally and continuously arranged and connected to a supporting frame (46) via connecting portions (44), the supporting frame (46) having positioning means (48); and in which the three components are sandwiched together with an insulation piece provided between each adjacent pair of metal components.

6. A process according to claim 5, wherein the two metal planes comprise a power supply plane (20) and a ground plane (32).

7.  A process according to claim 6, further comprising the steps of:

         punching the first insulation tape trip (40) to cut and remove at least one of first insulation tape pieces (42a) and provisionally adhering the first insulation tape piece (42a) to at least one of the power supply planes (20) of the power supply strip (18); and,

         punching the second insulation tape strip (40) to cut and remove at least one of second insulation tape pieces (42b) and provisionally adhering the second insulation tape piece (42b) to at least one of the ground planes (32) of the ground plane strip (30).

8.  A process according to claim 7, further comprising the steps of:

         punching the power supply plane strip (18) to cut and remove the at least one power supply plane (20) and laminating the power supply plane (2) to heat-press and provisionally adhere it to the at least one lead frame (12) of the lead frame strip (10); and,

         punching the ground plane strip (30) to cut and remove the at least one ground plane (32) and laminating the ground plane (32) to heat-press and adhere it to the at least one power supply plane (20) already adhered to the at least one lead frame (12).

9.  A process according to claim 5 or 6, in which the first (42a) and second (42b) insulation tape pieces are provisionally adhered to two of the metal component strips (10,18,30), and then all three of the metal component strips (10,18,30) are positioned with respect to one another using their positioning means (16,28,39) and are heat-pressed to laminate them together (Fig. 9).

# Fig. 1

C    B

E

54a    C1    18    B1    D

30

54b    A2    A1    A

10

# Fig. 2

16    14    12    10

# Fig. 3

18

22 20 24

26 28

# Fig. 4

34 32 30

39 36 38

# Fig. 5

42 40

48 46 44

# Fig. 6

# Fig. 7

# Fig. 8

# Fig. 9

# Fig. 10
## (PRIOR ART)